(19) **Europäisches Patentamt**

**European Patent Office**

**Office européen des brevets**

(11) Veröffentlichungsnummer: **0 250 393 B1**

(12) **EUROPÄISCHE PATENTSCHRIFT**

(45) Veröffentlichungstag der Patentschrift: **06.05.92**

(21) Anmeldenummer: **87890131.3**

(22) Anmeldetag: **11.06.87**

(51) Int. Cl.⁵: **H05K 7/14**

(51) Int. Cl.⁵: **H05K 7/14**

(54) **Halterung für Leiterplatten.**

(30) Priorität: **16.06.86 AT 1628/86**

(43) Veröffentlichungstag der Anmeldung:
**23.12.87 Patentblatt 87/52**

(45) Bekanntmachung des Hinweises auf die
Patenterteilung:
**06.05.92 Patentblatt 92/19**

(84) Benannte Vertragsstaaten:
**AT BE CH DE ES FR GB GR IT LI LU NL SE**

(56) Entgegenhaltungen:
**EP-A- 0 182 070**
**DE-B- 134 126**
**DE-B- 1 812 010**
**DE-U- 7 824 483**

(73) Patentinhaber: **Alcatel Austria Aktiengesellschaft**
**Scheydgasse 41**
**A-1210 Wien(AT)**

(72) Erfinder: **Benthen, Peter**
**Auhofstrasse 134/2**
**A-1130 Wien(AT)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services
(3.08/2.19/2.0)

# Beschreibung

Die Erfindung bezieht sich auf eine Halterung mit Leiterplatten, die elektrische Schaltungselemente samt den zugehörigen Leitungsverbindungen tragen und parallel neben- oder übereinander an Leisten verankert sind, die im Abstand voneinander quer zu den Leiterplatten an einem Tragkörper, z.B. an einem Gehäuse, angeordnet sind und für die Aufnahme der Leiterplatten Schlitze aufweisen.

Eine Halterung dieser Art ist aus der DE-B- 18 12 010 bekannt. Dabei sind die Leisten U-förmig ausgebildet und mit ihrem geschlossenen Boden den Leiterplatten zugewendet. An diesen sind zwei im Abstand voneinander befindliche Hilfsleisten befestigt, die an einem Ende jeweils zwei parallel nebeneinander angeordnete Laschen tragen, mit denen sie in die Schlitze der Leisten eingreifen. Die Laschen weisen Löcher auf, durch die ein im Inneren jeder U-förmigen Leiste vorgesehener Stab hindurchgesteckt ist. Auf diese Weise sind die Leiterplatten an zwei Stellen ihrer Stirnseite an einem Tragkörper verankert. Wenn einer der beiden Stäbe aus den Laschen herausgezogen wird, können die Leiterplatten um den anderen Stab als Achse verschwenkt werden. Durch Herausziehen beider Stäbe ist es möglich, die Leiterplatten ganz zu demontieren und auszutauschen.

Diese bekannte Halterung ist zwar einfacher als die vorher verwendeten Halterungen, bei denen die Leiterplatten zwischen spezielle Führungsleisten mit U-förmigem Querschnitt eingeschoben wurden (DE-B- 11 34 126). Die erforderlichen Hilfsleisten mit den an jeder Befestigungsstelle vorgesehenen beiden Laschen und die U-förmigen Befestigungsleisten mit Schlitzen und Stäben verursachen aber noch immer einen beträchtlichen Aufwand bei der Herstellung. Außerdem ist diese Halterung schwierig zu betätigen. Das Einführen der Verankerungsstäbe in die Laschen der Leiterplatten erfordert besondere Sorgfalt und wenn ein Stab herausgezogen wird, werden immer alle Leiterplatten zugleich entriegelt, wodurch es beispielsweise schwer ist, nur eine einzige Leiterplatte auszutauschen.

Der Erfindung liegt die Aufgabe zugrunde, die bekannten Halterungen noch weiter zu vereinfachen und so zu verbessern, daß auch die Leiterplatten einfach ausgebildet sein und unabhängig von der Verriegelung einzeln beliebig ausgetauscht werden können.

Die erfindungsgemäße Halterung ist dadurch gekennzeichnet, daß als Leisten zwei einfache Schienen vorgesehen sind, deren jeweils einer Leiterplatte zugeordneten Schlitze in Einschubrichtung verschieden tief ausgebildet sind, und daß die Leiterplatten wenigstens an der in den weniger tiefen Schlitz eingreifenden Stelle mit einem Querschlitz versehen sind, mit dem Sie auf die Schiene aufgesteckt sind. Bei dieser Ausbildung der Halterung sind zum Verankern jeder Leiterplatte nur zwei Schlitze in den beiden Schienen und ein weiterer Querschlitz in der Leiterplatte selbst vorgesehen. Die beiden Schlitze in den Schienen sichern die Leiterplatte in Längsrichtung der Schienen und der Querschlitz in der Leiterplatte verankert diese quer zu den Schienen. Die für die sichere Halterung der Leiterplatten insgesamt erforderlichen Vorkehrung sind somit denkbar einfach. Auch das Einsetzen und Herausnehmen der Leiterplatten aus der Halterung erfolgt unabhängig für jede Leiterplatte, wobei es möglich ist, die Platte um einen Auflagepunkt an einer der beiden Schienen zu verschwenken. Der Querschlitz in den Leiterplatten kann das dazu erforderliche Spiel aufweisen. Es kann auch im Bereich jeder Schiene ein Querschlitz in der Leiterplatte vorgesehen sein.

In weiterer Ausgestaltung der Erfindung können die Schlitze der Schienen und/oder die Querschlitze der Leiterplatten an ihrem Eingang trichterförmig erweitert sein. Dies erleichtert das Einschieben der Leiterplatten in die Schienen und auch das Verschwenken der Leiterplatten um eine am Grund der Querschlitze liegende Schwenkachse.

Bei einer einfachen Ausbildung der Erfindung sind beide Schienen von den Schenkeln eines U-förmigen Bügels gebildet, der am Tragkörper fest montiert ist. Dieser einfache Bügel mit Schlitzen in seinen Schenkeln bildet die einzig notwendige Vorkehrung für die Verankerung der Leiterplatten an einem Gehäuse od.dgl.

Eine zusätzliche Sicherung der Leiterplatten in der Haltung kann erfindungsgemäß dadurch erreicht werden, daß im Abstand von den Schienen an den Leiterplatten wenigstens eine Befestigungslasche vorgesehen ist, die am Tragkörper fixierbar ist, z.B. durch eine Schraube, eine Rasteinrichtung od.dgl. Die Leiterplatten können dann in die Schlitze der Schienen eingeschoben, in die richtige Position verschwenkt und schließlich festgeschraubt oder auf andere Weise befestigt werden. Es ist auch möglich, die Schlitze in den Leisten und auch in den Leiterplatten so eng auszuführen, daß beim gegenseitigen Eingriff eine Reibungsverbindung entsteht.

Die Befestigungslasche kann von einer an der Leiterplatte befestigten Winkelschiene gebildet sein, die an einer Erdungsschiene des Tragkörpers elektrisch leitend festgeschraubt ist. Dadurch wird mit der Sicherung der Leiterplatten in der Halterung zugleich eine Erdung erzielt.

Für den elektrischen Anschluß der Leiterplatten kann über jeder Halterungsstelle für eine Leiterplatte eine Stekkerleiste angeordnet sein, in die ein an der Leiterplatte befestigter Stecker einsteckbar ist.

2

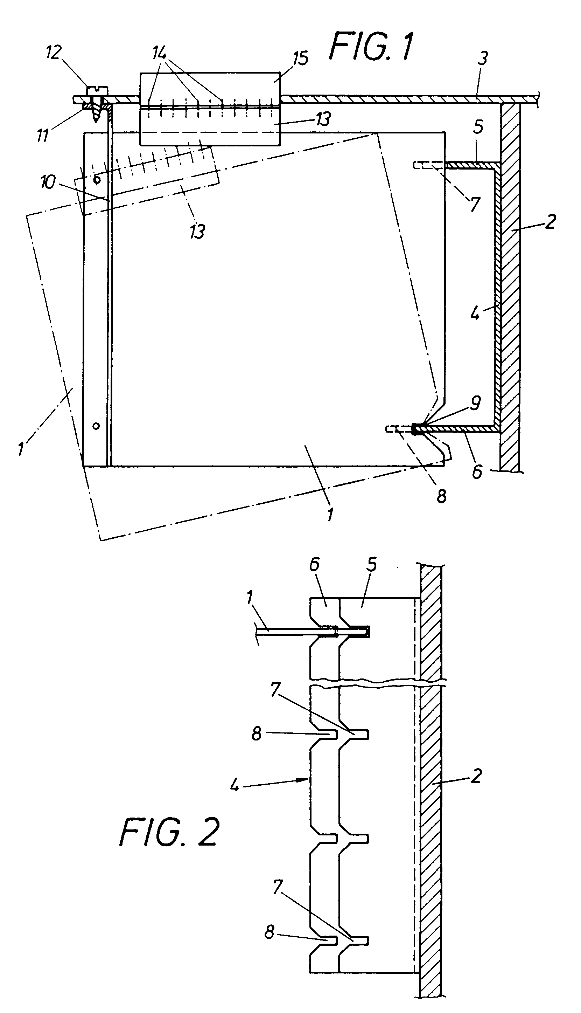

In der Zeichnung ist ein Ausführungsbeispiel der Erfindung dargestellt. Fig. 1 zeigt die erfindungsgemäße Halterung in Seitenansicht, teilweise im Schnitt, und Fig. 2 dazu eine teilweise geschnittene Draufsicht.

Die dargestellte Halterung für die mit 1 bezeichneten Leiterplatten ist in einem Gehäuse angeordnet, von dem in der Zeichnung nur eine Seitenwand 2 und eine Deckplatte 3 schematisch veranschaulicht sind. Die Seitenwand 2 bildet einen Tragkörper für einen U-förmigen Bügel 4, der mit seinem Rücken an der Seitenwand 2 befestigt ist und dessen Schenkel zwei Schienen bilden, u.zw. eine obere Schiene 5 und eine untere Schiene 6. In beiden Schienen 5,6 sind nebeneinander mehrere Schlitze 7 und 8 vorgesehen, wobei die Schlitze 7 in der oberen Schiene 5 jeweils über einem gleich ausgebildeten Schlitz 8 in der unteren Schiene 6 liegen. Aus Fig. 2 ist zu erkennen, daß die Schlitze 7,8 an ihrem Eingang trichterförmig erweitert sind. Die untere Schiene 6 ist breiter als die obere Schiene 5 und die Schlitze 8 in der unteren Schiene 6 ragen weniger weit gegen die Seitenwand 2 und den Rücken des U-förmigen Bügels 4 vor als die Schlitze 7, wie insbesondere aus Fig. 2 ersichtlich ist.

Aus Fig. 1 ist zu erkennen, daß in der Leiterplatte 1 ein Querschlitz 9 vorgesehen ist, der in der Größe und in der Form ungefähr mit den Schlitzen 7 und 8 in den Schienen 5,6 übereinstimmt. Auch der Eingang des Querschlitzes 9 ist trichterförmig erweitert. Die Leiterplatte 1 ist in den Schlitz 8 der unteren Schiene 6 des Bügels 4 eingeschoben und übergreift mit dem Querschlitz 9 die Schiene 6. Der Schlitz 8 sichert dabei die Leiterplatte 1 gegen seitliches Verschieben, wogegen der Querschlitz 9 die Leiterplatte 1 auf der unteren Schiene 6 abstützt und so die Leiterplatte 1 in vertikaler Richtung hält. In Fig. 1 ist auch gezeigt, daß die Leiterplatte 1 um ihre Auflagestelle auf der Schiene 6 als Achse verschwenkt werden kann. Sie kann in der strichpunktiert dargestellten, leicht nach unten gekippten Stellung in die untere Schiene 6 eingehängt und dann in die voll ausgezeichnete Stellung nach oben verschwenkt werden. Dabei greift die Leiterplatte 1 mit ihrer Stirnseite in einen Schlitz 7 in der oberen Schiene 5 ein. Auf diese Weise kann eine Anzahl von Leiterplatten 1 parallel nebeneinander in die Halterung eingesetzt werden.

Zur zusätzlichen Verankerung der Leiterplatte 1 ist an dieser eine Winkelschiene 10 befestigt, deren oberes Ende als Lasche 11 umgebogen und mit Hilfe einer Schraube 12 an der Deckplatte 3 befestigt ist. Anstelle der Schraube 12 kann auch eine Rasteinrichtung od.dgl. vorgesehen sein. Wenn die Schlitze 7 in der oberen Schiene 5 im Verhältnis zur Dicke der Leiterplatten 1 eng ausgebildet sind, kann auch eine Reibverbindung beim Einstecken der Leiterplatten erzielt werden, wobei eine eigene zusätzliche Sicherung der Leiterplatten 1 überflüssig ist.

Zur Herstellung des elektrischen Anschlusses der Leiterplatten 1 ist an deren Oberseite ein Stekker 13 befestigt, der mit nur schematisch angedeuteten Kontaktstiften 14 in eine Steckerleiste 15 an der Deckplatte 3 eingreift. Die Deckplatte 3 oder eine auf dieser befestigte Leiste kann als Erdungsschiene dienen, so daß beim Festschrauben der Lasche 11 zugleich eine Erdung der Winkelschiene 10 erfolgt, die dann als Erdungsschiene für die Leiterplatte 1 verwendet werden kann.

**Patentansprüche**

1. Halterung mit Leiterplatten, die elektrische Schaltungselemente samt den zugehörigen Leitungsverbindungen tragen und parallel neben- oder übereinander an Leisten verankert sind, die im Abstand voneinander quer zu den Leiterplatten an einem Tragkörper, z.B. an einem Gehäuse, angeordnet sind und für die Aufnahme der Leiterplatten Schlitze aufweisen, dadurch gekennzeichnet, daß als Leisten zwei einfache Schienen (5,6) vorgesehen sind, deren jeweils einer Leiterplatte (1) zugeordneten Schlitze (7,8) in Einschubrichtung der Leiterplatte (1) verschieden tief ausgebildet sind, und daß die Leiterplatten (1) wenigstens an der in den weniger tiefen Schlitz (8) eingreifenden Stelle mit einem Querschlitz (9) versehen sind, mit dem sie auf die Schiene (6) aufgesteckt sind.

2. Halterung nach Anspruch 1, dadurch gekennzeichnet, daß die Schlitze (7,8) der Schienen (5,6) und/oder die Querschlitze (9) der Leiterplatten (1) an ihrem Eingang trichterförmig erweitert sind.

3. Halterung nach Anspruch 1 oder 2, dadurch gekennzeichnet, daß beide Schienen (5,6) von den Schenkeln eines U-förmigen Bügels (4) gebildet sind, der am Tragkörper (2) montiert ist.

4. Halterung nach Anspruch 1, 2 oder 3, dadurch gekennzeichnet, daß im Abstand von den Schienen (5,6) an den Leiterplatten (1) wenigstens eine Befestigungslasche (11) vorgesehen ist, die am Tragkörper (3) fixierbar ist, z.B. durch eine Schraube (12), eine Rasteinrichtung od.dgl.

5. Halterung nach Anspruch 4, dadurch gekennzeichnet, daß die Befestigungslasche (11) von einer an der Leiterplatte (1) befestigten Winkelschiene (10) gebildet ist, die an einer Erdungschiene des Tragkörpers (3) elektrisch leitend festgeschraubt ist.

6. Halterung nach einem der Ansprüche 1 bis 5, dadurch gekennzeichnet, daß über jeder Halterungsstelle für eine Leiterplatte (1) eine Stek-kerleiste (15) angeordnet ist, in die ein an der Leiterplatte (1) befestigter Stecker (13) einsteckbar ist.

## Claims

1. Fixing device with printed circuit boards, which carry electrical switch components together with the accompanying circuit connections and which are anchored parallelly side by side or above one another to strips, which are arranged at some distance of one another crosswisely to the printed circuit boards in a carrying device, e.g. in a case, which show slits for the insertion of the printed circuit boards, characterized in that as strips are two simple rails (5,6) foreseen, the slits (7,8) of which being positioned on each of the printed circuit boards (1) are shaped with different depths in the direction of insertion and that the printed circuit boards (1) are provided with a crowwise slit (9) at least at the postion of the less deep slit (8), with which they are attached to the rail (6).

2. Fixing device according to claim 1, characterized in that the slits (7,8) of the rails (5,6) and/or the crosswise slits (9) of the printed circuit boards (1) are enlarged at their openings in a funnel-shaped manner.

3. Fixing device according to claim 1 or 2, characterized in that the two rails (5,6) are formed by the legs of a U-shaped bracket (4), which is fixed to the carrying device (2).

4. Fixing device according to claim 1,2 or 3, characterized in that at some distance of the rails (5,6) at least one fixing link (11) is intended on the printed circuit boards (1), which can be fixed to the carrying device (3), e.g. by means of a screw (12), a catching device or the like.

5. Fixing device according to claim 4, characterized in that the fixing link (11) is formed by an angle rail (10), which is fastened to the printed circuit board (1) and which is screwed on to an earthing rail of the carrying device (3) in an electrically conductive manner.

6. Fixing device according to one of the claims 1 to 5, characterized in that above each fixing point a multiway connector (15) is arranged for the printed circuit board (1), into which a plug (13) can be inserted, which is fastened to the printed circuit board (1).

## Revendications

1. Support muni de cartes à circuit-imprimé comportant des éléments de circuit électrique ainsi que les connexions électriques qui leur sont associées et qui sont ancrées de façon parallèlement, l'une à côté de l'autre, ou l'une au-dessus de l'autre, sur des barrettes disposées à distance l'une de l'autre transversalement par rapport aux cartes à circuit imprimé sur un corps de support, par exemple sur un boîtier, ces barrettes comportant des rainures pour recevoir les cartes à circuit imprimé, caractérisé en ce que les barrettes sont constituées par deux rails simples (5, 6) dont chaque rainure (7, 8) associée à une carte à circuit imprimé (1) présente, dans le sens d'introduction des plaquettes à circuit imprimé (1), une profondeur différente, et en ce que les cartes à circuit imprimé (1) sont munies, au moins au point d'engagement avec la rainure (8) de moindre profondeur, d'une rainure transversale (9) grâce à laquelle les cartes sont enfichées sur le rail (6).

2. Support selon la revendication 1, caractérisé en ce que les rainures (7, 8) des rails (5, 6) et/ou les rainures transversales (9) des cartes à circuit imprimé (1) s'évasent à leur entrée.

3. Support selon la revendication 1 ou 2, caractérisé en ce que les deux rails (5, 6) sont constitués par les branches d'un étrier (4) en forme de U qui est monté sur le corps de support (2).

4. Support selon la revendication 1,2 ou 3, caractérisé en ce que, sur les cartes à circuit imprimé (1), est prévu, à distance des rails (5, 6), au moins une attache de fixation (11) susceptible d'être fixée sur le corps de support (3) au moyen par exemple, d'une vis (12), d'une fixation à encliquetage, ou similaire.

5. Support selon la revendication 4, caractérisé en ce que les attaches de fixation (11) sont formées par un rail coudé (10) fixé sur la carte à circuit imprimé (1) et qui est susceptible d'être fixé rigidement par vissage, de façon électriquement conductrice, sur un rail de mise à la terre du corps de support (3).

6. Support selon l'une quelconque des revendications 1 à 5, caractérisé en ce qu'au-dessus de chaque position de maintien d'une carte à circuit imprimé (1) est disposée une barrette d'enfichage dans laquelle peut s'enficher un connecteur électrique (13) fixé sur une carte à circuit imprimé (1).

FIG. 1

FIG. 2